# EUROPEAN PATENT SPECIFICATION

(11) **EP 0 930 376 B1**
(45) Date of publication and mention of the grant of the patent: **02.04.2003**
(21) Application number: 98123756.3
(22) Date of filing: 14.12.1998
(51) Int. Cl.: C23C 14/22

(54) **Method of processing substrate**
Verfahren zur Substratbearbeitung
Méthode de traitement du substrat

(30) Priority: 15.12.1997 JP 34480497; 08.12.1998 JP 34902698
(43) Date of publication of application: 21.07.1999
(73) Proprietor: CANON KABUSHIKI KAISHA, Tokyo (JP)
(72) Inventor: Suzuki, Nobumasa, Ohta-ku, Tokyo (JP)
(74) Representative: Pellmann, Hans-Bernd, Dipl.-Ing.

(56) References cited:
- EP-A- 0 880 164
- EP-A1- 0 421 348
- US-A- 5 449 880

## Description

### BACKGROUND OF THE INVENTION

### Field of the Invention

The present invention relates to a method of processing a substrate, specifically a plasma processing method, more specifically a microwave plasma processing method of conducting plasma processing such as Chemical vapor deposition (CVD), etching or ashing.

### Related Background Art

CVD, etching and ashing are conventionally known as a plasma processing method.

Ashing or etching processing using plasma includes a method of introducing an ashing gas or an etchant gas into a processing chamber while supplying therein electric energy such as microwaves, exciting and decomposing the gas to generate plasma in the processing chamber, and ashing or etching the surface of a substrate to be processed placed in the processing chamber.

In addition, plasma CVD includes a method of introducing a raw material gas into a plasma generation chamber or a film formation chamber while supplying therein electric energy such as microwaves, generating plasma in the plasma generation chamber to excite and decompose the gas, and forming a deposited film on a substrate placed in the film formation chamber.

In particular, in the plasma processing method using microwaves as electric energy, since microwaves are used as a gas excitation source, electric fields of a high frequency can be used to accelerate electrons, thereby efficiently ionizing and exciting gas molecules. Thus, the microwave plasma processing method has the advantages of having high efficiencies in ionization, excitation and decomposition of a gas, forming high density plasma with relatively ease, and executing high-quality processing at a high speed at a low temperature. In addition, since microwaves penetrate a dielectric, a plasma processing apparatus can be configured as an electrodeless discharge type to execute very pure plasma processing.

Plasma processing using electron cyclotron resonance (ECR) has been put to practical use to further increase the speed of the microwave plasma processing method. In ECR, when the magnetic flux density is 87.5 mT, the electron cyclotron frequency at which electrons revolve around the magnetic force line agrees with the general frequency of microwaves, 2.45 GHz, so that electrons absorb microwaves as in resonance and are accelerated to generate high density plasma.

Moreover, a microwave plasma processing apparatus using an annular waveguide having a plurality of slots in its inner side has recently been proposed as an apparatus for uniformly and efficiently introducing microwaves (Japanese Patent Application Laid-Open No. 3-293010).

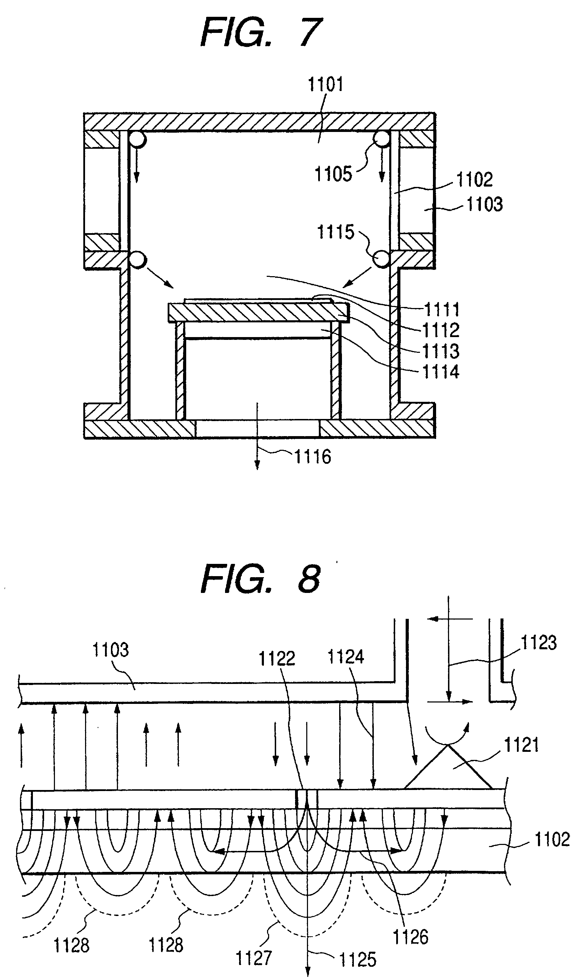

FIG. 7 shows this microwave processing apparatus, and FIG. 8 shows its plasma generation mechanism. Reference numeral 1101 designates a plasma generation chamber; 1102 is a dielectric for separating the plasma generation chamber 1101 from the atmosphere; 1103 is a slotted endless annular waveguide for introducing microwaves into the plasma generation chamber 1101; 1105 is means for introducing a gas for generating plasma; 1111 is a plasma processing chamber connected to the plasma generation chamber 1101; 1112 is a substrate to be processed; 1113 is a support for the substrate 1112; 1114 is a heater for heating the substrate 1112; 1115 is a processing gas introduction means, 1116 is an exhaust direction; 1121 is a two-way distribution block for distributing microwaves in right and left directions; 1122 is a slot; 1123 is microwaves introduced into the annular waveguide 1103; 1125 is leakage waves of the microwaves introduced into the plasma generation chamber 1101 through the slot 1112 and the dielectric 1102; 1126 is surface waves of the microwaves propagating through the slot 1122 and the dielectric 1102; 1127 is plasma generated by the leakage waves; and 1128 is plasma generated by the surface waves.

Plasma generation and plasma processing are conducted as follows. The plasma generation chamber 1101 and the processing chamber 1111 are evacuated via an exhaust system (not shown in the drawings) usually until a vacuum higher by three orders or more than the processing pressure is established. Subsequently, a gas for generating plasma is introduced at a predetermined flow rate into the plasma generation chamber 1101 via the gas introduction means 1105. Then, a conductance valve (not shown in the drawings) provided in the exhaust system (not shown in the drawings) is regulated to maintain the inside of the plasma generation chamber 1101 at a predetermined pressure. Desired power is supplied from a microwave power supply (not shown in the drawings) to the plasma generation chamber 1101 via the annular waveguide 1103.

The microwaves 1123 introduced into the annular waveguide 1103 are distributed by the distribution block 1121 in two lateral directions (right and left directions in FIG. 8) and then propagate at an inline wavelength longer than in a free space. The leakage waves 1125 introduced from the slots 1122 installed at an interval of a half or quarter of the inline wavelength, into the plasma generation chamber 1101 through the dielectric 1102 generate plasma 1127 near the slots 1122. In addition, microwaves incident at the polarization angle or more relative to a straight line perpendicular to the surface of the dielectric 1102 are totally reflected from the first surface of the dielectric 1102 and propagate over this surface as the surface waves 1126. Electric fields seeping from the surface waves 1126 generate the plasma 1128. In this case, when a processing gas is introduced into the processing chamber 1111 via the processing gas introduction pipe 1115, it is excited by high density plasma generated to process the surface of the substrate to be processed 1112 placed on the support 1113.

Such a microwave plasma processing apparatus can be used with microwave power of 1 kW or more to generate high-density low-potential plasma having electron density 10¹²/cm³ or more, electron temperature 3 eV or less, and plasma potential 20 V or less in a space having a large diameter of 300 mm or more at an uniformity of ± 3 %. Therefore, by using this apparatus, a gas sufficiently reacts to be supplied in an active state to the substrate, and damage to the surface of the substrate caused by incident ions is reduced to enable high-quality high-speed processing even at a low temperature.

However, in the case of using the microwave plasma processing apparatus which generates high-density low-potential plasma as shown in FIGS. 7 and 8, although the processing itself can be conducted at a high speed, a large amount of time is required for the operations other than plasma processing, for example, the transfer of the substrate, heating, or the exhaust or ventilation of the processing chamber. Consequently, the speed of the entire processing cannot be increased unless, in particular, the exhaust time is reduced.

A microwave plasma processing apparatus of the above kind is disclosed in EP-A-0 880 164 which is an earlier European patent application published after the priority date of the present application.

### SUMMARY OF THE INVENTION

It is a main object of the invention to provide a plasma processing method that enables the speed of the entire processing to be increased and reduces the time required for operations other than plasma processing, in particular, the exhaust time.

To achieve the above object, the present invention provides a plasma processing method according to claim 1. Developments of the invention are set forth in the dependent method and use claims.

According to the present invention by using as the ventilation gas a gas containing at least one component of a plasma processing gas, the processing gas and electric energy are introduced into the plasma processing chamber to start plasma processing when the internal pressure of the plasma processing chamber reaches to a plasma processing pressure during the step of exhausting the ventilation gas, whereby the exhaust time can be reduced to accomplish the above object.

### BRIEF DESCRIPTION OF THE DRAWINGS

FIG. 1 is a flow chart for explaining the plasma processing method of the present invention;
FIGS. 2A and 2B are schematic plan and cross-sectional views, respectively, for explaining one example of a system of gradually increasing the flow rate of a processing gas so as to maintain a pressure according to one embodiment of the plasma processing method of the present invention;
FIG. 3 is a schematic cross-sectional view for explaining one example of a system of gradually reducing the conductance of an exhaust system so as to maintain a pressure according to one embodiment of the plasma processing method of the present invention;
FIG. 4 is a schematic cross-sectional view for explaining one example of the plasma processing apparatus according to one embodiment of the present invention;
FIG. 5 is a graph for showing a relationship between the time and the internal pressure of the plasma processing chamber in the present invention;
FIG. 6 is a graph for showing a relationship between the time and the internal pressure of the plasma processing chamber in a comparative example;
FIG. 7 is a schematic cross-sectional view for explaining a conventional microwave plasma processing apparatus; and
FIG. 8 is a schematic partial cross-sectional view for explaining a plasma generation mechanism of the conventional microwave plasma processing apparatus.

### DETAILED DESCRIPTION OF THE PREFERRED EMBODIMENTS

Preferred embodiments of the present invention are described below.

### (First Embodiment)

A plasma processing apparatus used for the present embodiment may be composed of, for example, a plasma processing chamber, means for supporting a substrate to be processed installed in the plasma processing chamber, means for exhausting the inside of the plasma processing chamber, means for introducing a processing gas into the plasma processing chamber, and means for introducing electric energy into the plasma processing apparatus.

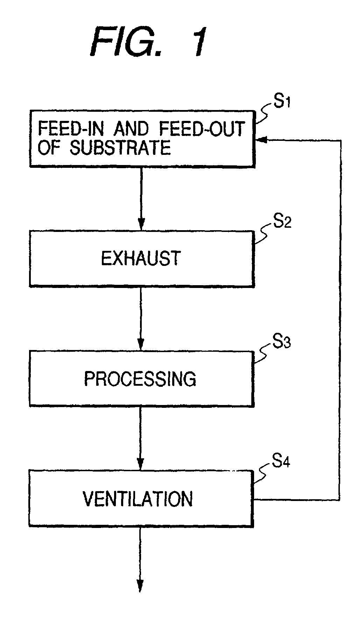

FIG. 1 is a flow chart for showing the plasma processing method of the present invention. The present method mainly comprises a step of feeding a substrate to be processed in and out from a plasma processing chamber (S₁), an exhaust step (S₂), a processing step (S₃) and a ventilation step (S₄). Specifically, the representative steps of the method of the present invention include the steps of installing a substrate to be processed on a substrate supporting member, exhausting the inside of a plasma processing chamber, introducing a processing gas into the plasma processing chamber to maintain the inside of the chamber at a predetermined pressure (plasma processing pressure), introducing electric energy into the plasma processing chamber to generate plasma and conduct plasma processing, stopping the electric energy, stopping the exhaust, introducing a ventilation gas into the plasma processing chamber to return the inside of the chamber to the atmospheric pressure, feeding the substrate out to the outside of the plasma processing chamber, installing another substrate to be processed in the plasma processing chamber, exhausting the ventilation gas, when the plasma processing pressure is reached, introducing a plasma processing gas so as to maintain the pressure, and introducing electric energy and newly starting plasma processing.

In the plasma processing method according to the present embodiment, preferable pressure maintenance methods include (1) making the conductance of an exhaust system constant and gradually increasing the flow rate of a plasma processing gas, (2) making the flow rate of the gas constant and gradually reducing the conductance of the exhaust system, and (3) gradually increasing the flow rate of the gas while gradually reducing the conductance of the exhaust system.

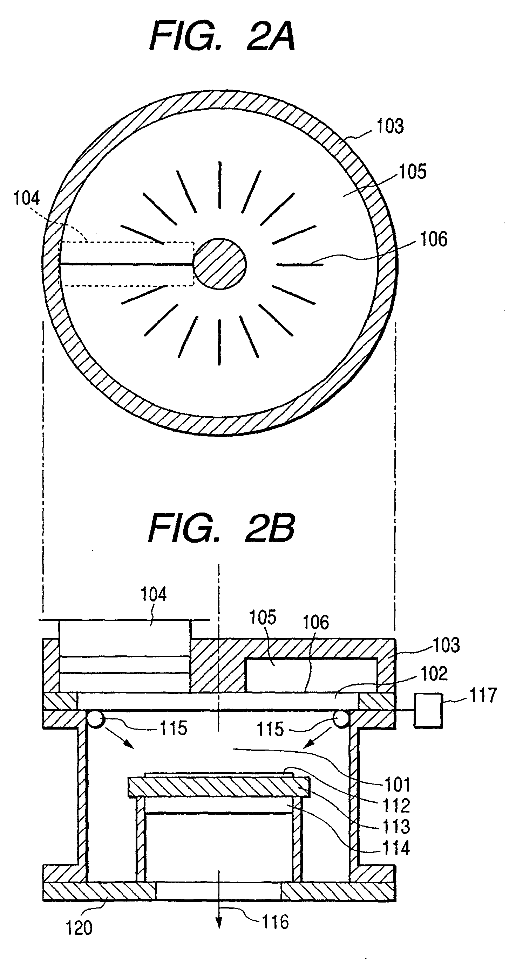

FIGS. 2A and 2B are schematic views for explaining one example of a pressure maintenance method using a system for gradually increasing the flow rate of a processing gas in the plasma processing method of the present invention. FIG. 2A is a schematic plan view when a microwave introduction means 103 in FIG. 2B is seen from above. As shown in FIG. 2B, numeral 101 indicates a plasma processing chamber; 102 indicates a dielectric for separating the plasma processing chamber 101 from the atmosphere; 103 indicates a microwave introduction means (an endless annular waveguide provided with plate-like slots) for introducing microwaves into the plasma generation means 101; 104 indicates an introduction portion for introducing microwaves into the plate-like slotted annular waveguide 103, the introduction portion having a two-way distribution block; 105 indicates a microwave propagation space for propagating microwaves provided in the plate-like slotted annular waveguide 103; 106 indicates a slot through which microwaves are introduced into the plasma processing chamber 101 from the plate-like slotted annular waveguide 103; 112 indicates a substrate to be processed; 113 indicates a member for supporting the substrate 112, 114 indicates a heater for heating the substrate 112; 115 indicates a processing gas introduction means; 116 indicates an exhaust (the arrow indicates an exhaust direction); and 117 indicates a processing gas flow rate control means. The processing gas introduction means 115 is also used as means for introducing a ventilation gas. The processing gas introduction means 115 is provided at an upper part within the plasma processing chamber 101, and both the ventilation gas and the processing gas can be supplied in a flesh state to the surface to be processed of the substrate 112.

Plasma generation and plasma processing are conducted as follows. After a first substrate has been processed, a gas containing at least one component of a processing gas is introduced into the plasma processing chamber 101 via the processing gas introduction means 115 to execute ventilation until the internal pressure of the chamber reaches the atmospheric pressure. After detaching a bottom plate 120 from the body of the chamber, the processed substrate 112 is fed out from the substrate supporting means 113 to the outside of the plasma processing chamber 101, using a transfer system (not shown in the drawings). A second substrate 112 to be processed is transferred onto the substrate supporting member 113 using the transfer system, and the substrate 112 is heated up to a desired temperature by using the heater 114. The inside of the plasma processing chamber is opened to the air at the time of feed-in and feed-out of the substrate. The inside of the plasma processing chamber 101 is evacuated via an exhaust system (not shown in the drawings). Since ventilation is conducted by using a gas containing at least one component of the processing gas, almost all gas components other than the processing gas have been removed when the internal pressure reaches a processing pressure value during the exhaust. In addition, to maintain the pressure at the value, the processing gas flow control means 117 is used to gradually increase the flow rate of the processing gas, and the processing gas is then introduced into the plasma processing chamber 101 via the processing gas introduction means 115. As the result, the processing gas can be earlier introduced into the plasma processing chamber, thereby reducing the time before the start of plasma processing and after the loading of the processed substrate on the substrate supporting member. In addition, by increasing the flow rate of the processing gas, it is possible to only maintain a constant pressure but also increase the abundance ratio of the gas molecules of the processing gas present in the plasma processing chamber, thereby enabling plasma to be generated efficiently.

While maintaining the pressure, a desired power from a microwave power supply (not shown in the drawings) is introduced into the plate-shaped annular waveguide 103 through the introduction portion 104. The introduced microwaves are divided into two, which propagate through the propagation space 105 in the lateral direction. The divided microwaves interfere with a portion opposite to the introduction portion 104 to enhance electric fields traversing the slot 106, every half inline wavelength, and are then introduced into the plasma processing chamber 101 via the slot 106 through the dielectric 102. The electric fields of the microwave introduced into the plasma processing chamber 101 accelerate electrons to generate plasma in the plasma processing chamber 101. In this case, the processing gas is excited by generated high density plasma to process the surface of the substrate 112 to be processed placed on the supporting member 113.

In the example shown in FIGS. 2A and 2B, specific materials and dimensions are described. The dielectric 102 is composed of a synthetic quartz and has a diameter of 299 mm and a thickness of 12 mm. The annular waveguide 103 provided with plate-shaped slots has a 27 mm x 96 mm inner-wall cross section and a central diameter of 202 mm, and is entirely composed of aluminum (Al) to reduce microwave propagation losses. Slots through which microwaves are introduced into the plasma processing chamber 101 are formed in the E plane of the waveguide 103, i.e., the side face parallel to the electric field vector within the waveguide. The slots are each shaped like a rectangle of length 42 mm and width 3 mm and are formed at an interval of a quarter of the inline wavelength in a radial state. The inline wavelength depends on the frequency of the microwaves used and the dimension of the cross section of the waveguide, and is about 159 mm in the case of using microwaves of frequency 2.45 GHz and the waveguide of the above dimensions. In the plate-shaped slotted annular waveguide 103, 16 slots are formed at an interval of about 39.8 mm. A 4E tuner, a directional coupler, an isolator, and a microwave power supply of 2.45 GHz frequency (not shown in the drawings) are sequentially connected to the plate-shaped slotted annular waveguide 103. In the present embodiment, slots may be formed on the H face crossing to the E face.

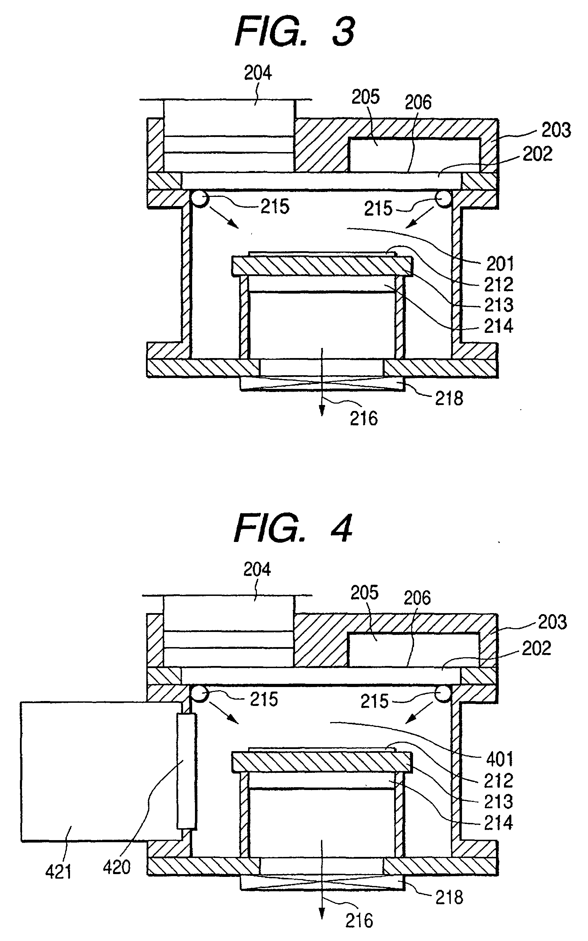

FIG. 3 is a schematic cross-sectional view for explaining one example of a pressure maintenance system using a method of gradually reducing the conductance of the exhaust system in the plasma processing method of the present invention. In FIG. 3, numerals 201 to 216 indicate the same members as those indicated by the numerals 101 to 116 in FIGS. 2A and 2B, respectively. Numeral 218 designates a conductance control valve.

In this example, the first step through the steps of, after ventilation, loading a second substrate 212 to be processed, heating the substrate, and exhausting the inside of the plasma processing chamber 201 may be executed in the same manner as in the preceding example. In this example in which the speed of processing is determined by the supply, the processing gas is introduced into the plasma processing chamber 201 via the processing gas introduction means 215 at a constant flow rate so that the pressure starts to be maintained when it reaches the processing pressure value during an exhaust, and the conductance control valve 218 of the exhaust system is used to gradually reduce the conductance. The subsequent introduction of microwaves and generation of plasma may be executed in the same manner as in the preceding example. In addition, specific materials and dimensions may be determined similarly to the preceding example.

The ventilation gas used for the plasma processing method of the present invention may be any gas as long as it contains at least one component of the plasma processing gas. In plasma CVD, etching and ashing, various plasma processing gasses such as raw material gas, additive gas, carrier gas, etching gas and ashing gas are used, but in the present invention such plasma processing gas is used as a part or all of the ventilation gas to reduce the exhaust time. For example, oxygen raw material gas, nitrogen raw material gas, carrier gas, etching gas, or ashing gas is preferably used as the ventilation gas. In addition, the ventilation gas used for the present invention may be any gas as long as it can reduce the exhaust time, but an optimal gas is preferably selected from the various processing gases by taking safety, costs, and flow rate ratio into consideration.

When the plasma processing method of the present invention is applied to processing for forming a film on a substrate by using the CVD (Chemical Vapor Deposition) method, any of the various gases conventionally used for the plasma CVD method may be used as the plasma processing gas.

When, for example, an Si based semiconductor film mainly composed of non-monocrystalline silicon is formed using the CVD method, the raw material gas containing Si atoms includes materials which are in a gaseous state at the room temperature and atmospheric pressure or can be easily gasified, for example, inorganic silane such as silane (SiH₄) or disilane (Si₂H₆); organic silane such as tetraethylsilane (TES), tetramethylsilane (TMS), dimethylsilane (DMS), dimethyldifluolosilane (DMDFS), or dimethyldichlorosilane (DMDCS); or halosilane such as SiF₄, Si₂F₆, Si₃F₈, SiHF₃, SiH₂F₂, SiCl₄, Si₂Cl₆, SiHCl₃, SiH₂Cl₂, SiH₃Cl, or SiCl₂F₂. In addition, the additive or carrier gas that can be mixed and introduced with the Si raw material gas includes H₂, He, Ne, Ar, Kr, Xe, and Rn. In this case, He, Ne, or Ar is preferably used as the ventilation gas. The non-monocrystalline silicon includes amorphous silicon (a-Si), microcrystalline silicon, polysilicon, or silicon carbide containing covalently bonded carbons.

When, for example, the Si compound based film such as Si₃N₄ or SiO₂ is formed using the CVD method, the raw material gas containing Si atoms includes materials which are in a gaseous state at the room temperature and atmospheric pressure or can be easily gasified, for example, inorganic silane such as SiH₄ or Si₂H₆; organic silane such as tetraethoxysilane (TEOS), tetramethoxysilane (TMOS), octamethylcyclotetrasilane (OMCTS), dimethyldifluolosilane (DMDFS), or dimethyldichlorosilane (DMDCS); or halosilane such as SiF₄, Si₂F₆, Si₃F₈, SiHF₃, SiH₂F₂, SiCl₄, Si₂Cl₆, SiHCl₃, SiH₂Cl₂, SiH₃Cl, or SiCl₂F₂. In addition, the nitrogen or oxygen raw material gas which is introduced simultaneously with the Si raw material gas includes N₂, NH₃, N₂H₄, hexamethyldisilazane (HMDS), O₂, O₃, H₂O, NO, N₂O, and NO₂. In this case, nitrogen (N₂) or oxygen (O₂) is preferably used as the ventilation gas.

When, for example, a metal film such as Al, W, MO, Ti, or Ta is formed using the CVD method, the raw material gas containing metal atoms includes organic metal such as trimethylaluminum (TMAl), triethylaluminum (TEAl), triisobutylaluminum (TIBAl), dimethylaluminum hydride (DMAlH), tungstencarbonyl (W(CO)₆), molybdenumcarbonyl (Mo(CO)₆), trimethylgallium (TMGa), or triethylgallium (TEGa); or metal halide such as AlCl₃, WF₆, TiCl₃, or TaCl₅. In addition, the additive or carrier gas that can be mixed and introduced with the metal raw material gas includes H₂, He, Ne, Ar, Kr, Xe, and Rn. In this case, He, Ne, or • Ar is preferably used as the ventilation gas.

When, for example, a metal compound film such as Al₂O₃, AlN, Ta₂O₅, TiO₂, TiN, or WO₃ is formed using the CVD method, the raw material gas containing metal atoms includes organic metal such as trimethylaluminum (TMAl), triethylaluminum (TEAl), triisobutylaluminum (TIBAl), dimethylaluminum hydride (DMAlH), tungstencarbonyl (W(CO)₆), molybdenumcarbonyl (Mo(CO)₆), trimethylgallium (TMGa), or triethylgallium (TEGa); or metal halide such as AlCl₃, WF₆, TiCl₃, or TaCl₅. In addition, the nitrogen or oxygen raw material gas that is introduced simultaneously with the metal material gas includes O₂, O₃, H₂O, NO, N₂O, NO₂, N₂, NH₃, N₂H₄, or hexamethyldisilazane (HMDS). In this case, O₂ or N₂ is preferably used as the ventilation gas.

When the plasma processing method according to the present invention is applied to the etching of the surface of the substrate, the plasma processing gas may be any of various gases conventionally used for plasma etching. Such an etching gas includes, for example, F₂, CF₄, CH₂F₂, C₂F₆, CF₂Cl₂, SF₆, NF₃, Cl₂, CCl₄, CH₂Cl₂, and C₂Cl₆. In this case, CF₄ or SF₆ is preferably used as the ventilation gas.

If the plasma processing method according to this invention is applied to the ashing removal of organic components such as photoresist from the surface of the substrate, the plasma processing gas may be any of various gases conventionally used for plasma ashing. Such an ashing gas includes, for example, O₂, O₃, H₂O, NO, N₂O, and NO₂. In this case, O₂ is preferably used as the ventilation gas.

Furthermore, the plasma processing method of the present invention is applicable to surface modification. In the surface modification, for example, Si, Al, Ti, Zn, or Ta is used as a substrate or a surface layer, and the plasma processing gas is suitably selected to conduct an oxidizing or nitriding treatment of the substrate or surface layer or to dope it with B, As or P.

The oxidizing gas used to oxidize the surface of the substrate includes, for example, O₂, O₃, H₂O, NO, N₂O, and NO₂. In addition, the nitriding gas used to nitride the surface of the substrate includes, for example, N₂, NH₃, N₂H₄, and hexamethyldisilazane (HMDS). In this case, O₂ or N₂ is preferably used as the ventilation gas.

Furthermore, the plasma processing method of the present invention is applicable to a cleaning method. The cleaning method cleans, for example, oxides, organic substances, or heavy metals.

The cleaning gas used for cleaning the organic substances on the surface of the substrate or the organic components such as photoresist on the surface of the substrate includes, for example, O₂, O₃, H₂O, NO, N₂O, and NO₂. The cleaning gas used for cleaning the inorganic substances on the surface of the substrate includes F₂, CF₄, CH₂F₂, C₂F₆, CF₂Cl₂, SF₆, and NF₃. In this case, O₂, CF₄, or SF₆ is preferably used as the ventilation gas.

In the present plasma processing method, the electric energy used for generating plasma may be microwaves, high frequencies, or direct currents as long as it can accelerate electrons to generate plasma when introduced. In totally increasing the processing speed, however, the microwaves is optimal which can generate high density plasma capable of increasing the speed of processing.

The microwave introduction means includes ordinary means such as a mono-pole antenna, dipole antenna, single-slot antenna, Rigitano coil, or a coaxial slot antenna. The increase in the speed of the total processing enabled by the reduction of the exhaust time according to the present method is more significant when the plasma processing itself is conducted at a high speed. Thus, in increasing the total processing speed, the optimal means is a multi-slot antenna such as an annular waveguide provided with plate-shaped slots or a waveguide provided with annular slots that can generate uniform plasma of a high density.

The microwave frequency used for the present plasma processing method is preferably selected from a range of 0.8 GHz to 20 GHz.

As a microwave permeating dielectric used for the present plasma processing method, an inorganic substance such as SiO₂ based quartz or glass, Si₃N₄, NaCl, KCl, LiF, CaF₂, BaF₂, Al₂O₃, AlN, or MgO is appropriate, but a film or sheet of an organic substance such as polyethylene, polyester, polycarbonate, cellulose acetate, polypropyrene, polyvinyl chloride, polyvinylidene chloride, polystyrene, polyamide, or polyimide is also applicable.

In the present plasma processing method, a magnetic-field generation means may be used to achieve processing at a lower pressure, i.e., a lower vacuum degree. Mirror fields can be applied as such magnetic fields, but magnetron fields are optimal that generates loop fields on a curve joining the centers of the plurality of slots in the annular waveguide provided with plate-shaped slots and that have a larger magnetic flux density of magnetic fields near the slot than near the substrate. In addition to coils, for example, permanent magnets can be used as a magnetic-field generation means. When coils are used, cooling means such as water cooling mechanism, air cooling or other cooling means may be used to prevent overheat.

To improve the quality of plasma processing, the surface of the substrate may be irradiated with ultraviolet rays. The light source capable of radiating light that is absorbed by the substrate to be processed or a gas attached to the substrate can be applied to this purpose, and the appropriate light source includes an excimer laser, an excimer lamp, a rare-gas resonance line lamp, or a low-pressure mercury lamp.

The processing pressure in the inside of the plasma processing chamber is preferably a range from 0.1 mTorr to 10 Torr, more preferably from 1 mTorr to 100 mTorr. In the case of etching, it is selected from a range from 0.5 mTorr to 50 mTorr, and in the case of ashing, it is selected from a range from 10 mTorr to 10 Torr. 760 Torr is equal to 101.325 kPa or 1 atm.

A pressure at the time of starting the plasma processing step S₃ is preferably set to a slightly higher vacuum degree than the pressure during plasma processing in consideration of slightly increasing the internal pressure of the chamber due to plasma generation. Specifically, it is preferable to reduce the internal pressure of the chamber up to a value smaller by one figure than the pressure value during plasma processing, more preferable to overshoot the reduction of the internal pressure to 90 % of the pressure value during plasma processing.

When a deposited film is formed using the present plasma processing method, various deposited films including insulating films such as Si₃N₄, SiO₂, Ta₂O₅, TiO₂, TiN, Al₂O₃, AlN and MgF₂ films, semiconductor films such as amorphous Si, polycrystalline Si, SiC and GaAs films, or metal films such as Al, W, Mo, Ti and Ta films, can be efficiently formed by suitably selecting a gas.

The substrate to be processed by the plasma processing method of the present invention may be made of a semiconductor or an electroconductive or electrically insulating substrate. The electroconductive substrate includes metal substrates such as Fe, Ni, Cr, Al, Mo, Au, Nb, Ta, V, Ti, Pt and Pb substrates or alloy substrates thereof such as brass and stainless steel substrates. The insulating substrate includes a film or sheet of an inorganic substance such as SiO₂ quartz or glass, Si₃N₄, NaCl, KCl, LiF, CaF₂, BaF₂, Al₂O₃, AlN, or MgO, or of an organic substance such as polyethylene, polyester, polycarbonate, cellulose acetate, polypropyrene, polyvinyl chloride, polyvinylidene chloride, polystyrene, polyamide, or polyimide.

Further, in the present invention, when the substrate to be processed is fed in or out from the plasma processing chamber, it is preferable to prevent the incorporation of an unnecessary gas contained in the air into the plasma processing chamber.

More specifically, it is preferable to continuously introduce a ventilation gas containing at least one component of a plasma processing gas into the plasma processing chamber to make the internal pressure of the chamber higher than the atmospheric pressure, or to change the air to the ventilation gas.

Furthermore, the present invention can be applied to, for example, thermal CVD and photo CVD other than the substrate processing by plasma generation.

In the plasma processing method of the present invention, when a gas containing at least vaporized water (H₂O) and oxygen gas (O₂) is used as the processing gas, oxygen gas (O₂) is preferably used as the ventilation gas.

Further, In the plasma processing method of the present invention, when a gas containing at least fluorine gas (F₂) and oxygen gas (O₂) is used as the processing gas, oxygen gas (O₂) is preferably used as the ventilation gas.

### (Second Embodiment)

In the plasma processing method according to the second embodiment, when the substrate to be processed is fed out from or in the plasma processing chamber, a ventilation gas containing at least one component of a plasma processing gas is used as the air communicating with the plasma processing chamber. The other points in the second embodiment are the same as those in the first embodiment.

FIG. 4 is a schematic cross-sectional view of the plasma processing apparatus for conducting the plasma processing method according to the present embodiment. As shown in FIG. 4, the plasma processing apparatus comprises a plasma processing chamber 401, a chamber 421, an open-close means 420 for separating the chambers by freely opening and closing. The above-mentioned "the air" means an air within the chamber 421.

According to the present embodiment, since a ventilation gas containing at least one component of a plasma processing gas is charged in the chamber 421, it is possible to prevent the incorporation of an unnecessary gas into the plasma processing chamber 401 at the time of feed-in and feed-out of the substrate. As the result, it is unnecessary to exhaust the inside of the plasma processing chamber even up to a high vacuum degree. Therefore, a time necessary from the feed-in and feed-out of the substrate to the plasma processing can be reduced.

Examples of the present invention are described below in detail, but the present invention is not limited to these examples.

### <Example 1>

In this example, an oxygen gas was used as a ventilation gas to ash photoresist according to the method described with reference to FIG. 1.

An interlayer silicon oxide (SiO₂) film which was an interlayer insulating film on the surface to be processed of a substrate 112 was etched, and via holes were formed to prepare a silicon (Si) substrate (φ8 inch). An oxygen gas was introduced into the plasma processing chamber 101 via the processing gas introduction opening 115 to conduct ventilation. An oxygen gas was used the ventilation gas. The Si substrate 112 was installed on a substrate supporting member 113, and the inside of the plasma processing chamber 101 was then evacuated via an exhaust system (not shown in the drawings).

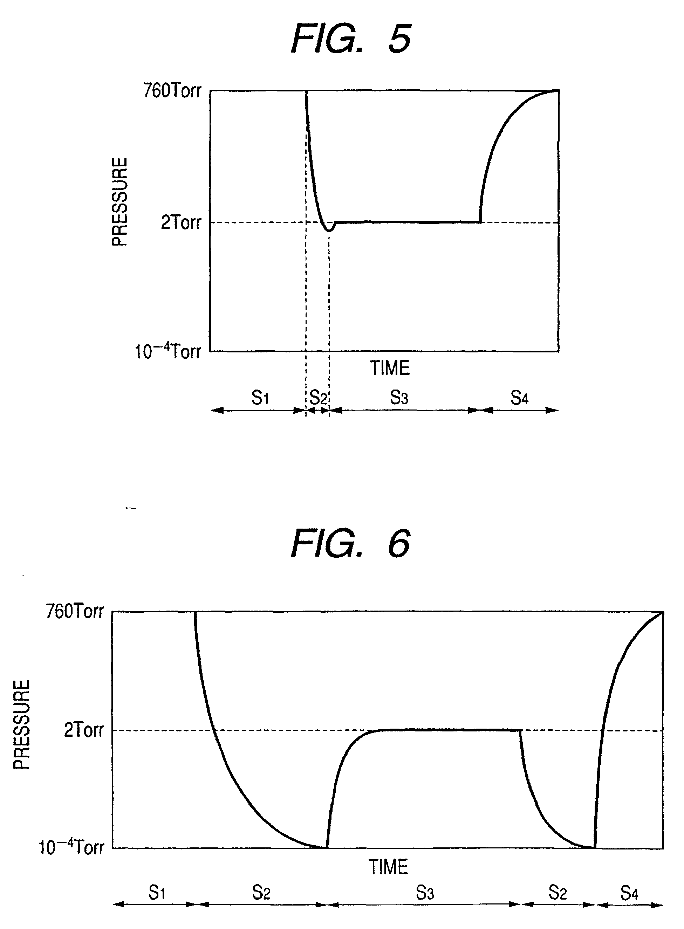

FIG. 5 is a graph showing the relationship between the time and the internal pressure of the plasma processing chamber in the present example. The transverse axis indicates a time, and the vertical axis indicates a pressure. Each time for conducting the above-mentioned steps S₁ to S₄ is indicated by arrows along the traverse axis. When the internal pressure reached 2 Torr, an oxygen gas was introduced into the plasma processing chamber 101 via the plasma processing gas introduction opening 115 while gradually increasing the flow rate of the gas up to 2 slm, so as to maintain the pressure of 2 Torr. At the same time, 1.5 kW power was supplied to the inside of the plasma processing chamber 101 from a 2.45 GHz microwave power supply via an annular waveguide 103 provided with plate-shaped slots to generate plasma in the plasma processing chamber 101. In this case, the oxygen gas introduced via the plasma processing gas introduction opening 115 was excited, decomposed, and reacted in the plasma processing chamber 101 to become ozone, which was transported toward the silicon substrate 112 to oxidize the photoresist thereon to vaporize and remove it.

This ashing rate was very high, 8.6 µm/min ± 8.5%, and the surface charge density exhibited a sufficiently low value of -1.3 x 10¹¹/cm². The throughput was 150 sheets/hour. As a comparative example, the processing was started after the inside of the chamber has been exhausted down to 10⁻⁴ Torr with using a nitrogen gas and without using a processing gas (oxygen gas) as a ventilation gas. FIG. 6 is a graph showing the relationship between the time and the internal pressure of the plasma processing chamber in the comparative example. The time required for conducting the step S₃ in the comparative example was the same as that in the present example. The throughput was about 1.4 times as large as the conventional throughput of 106 sheets/hour as the comparative example.

### <Example 2>

In this example, an oxygen gas was used as a ventilation gas to ash photoresist according to the method described with reference to FIG. 2.

The first step through the ventilation and exhaust step were carried out in the same manner as in Example 1. When the pressure reached 2 Torr, an oxygen gas was introduced into the plasma processing chamber 201 via the plasma processing gas introduction opening at a flow rate of 2 slm while using a conductance control valve 218 to gradually reduce the conductance of the exhaust, so as to maintain the pressure of 2 Torr. Thereafter, plasma generation and ashing were carried out in the same manner as in Example 1.

This ashing rate exhibited a very high value of 8.4 µm/min ± 8.5%, and the surface charge density exhibited a sufficiently low value of -1.1 x 10¹¹/cm². The throughput was 148 sheets/hour, which is about 1.4 times as large as the conventional throughput of 106 sheets/hour which was obtained by starting processing after the chamber has been exhausted down to 10⁻⁴ Torr without using a processing gas (oxygen gas) as a ventilation gas.

### <Example 3>

In this example, a silicon nitride film for a protecting a semiconductor device was formed by using a nitrogen gas as a ventilation gas according to the method described with reference to FIG. 1 and by using the plasma CVD method.

A p-type single-crystal silicon substrate (surface azimuth: <100>); resistivity: 10Ωcm) having the property of a p-type semiconductor provided with an interlayer SiO₂ film having a pattern (line and space: 0.5µm) of an aluminum (Al) wiring as a metal wiring was prepared as a substrate 112. A nitrogen gas was introduced into the plasma processing chamber 101 via the processing gas introduction opening 115 to conduct ventilation. The silicon (Si) substrate 112 was installed on a substrate supporting member 113 that had been heated up to 300°C by a heater 104, and the inside of the plasma processing chamber 101 was then evacuated to be in a vacuum state by an exhaust system (not shown in the drawings).

When the internal pressure of the chamber reached 20 mTorr, a nitrogen gas and an SiH₄ gas were introduced into the plasma processing chamber 101 via the plasma processing gas introduction opening 115 while gradually increasing the flow rates of the nitrogen gas and the SiH₄ gas up to 600 sccm and 200 sccm, respectively, so as to maintain the pressure at 20 mTorr. At the same time, 1.5 kW power was supplied to the inside of the plasma processing chamber 101 from a 2.45 GHz microwave power supply via an annular waveguide 103 provided with plate-shaped slots to generate plasma in the plasma processing chamber 101. In this case, the nitrogen gas introduced via the plasma processing gas introduction opening 115 was excited and decomposed in the plasma processing chamber 101 to become an active species, which was transported toward the silicon substrate 112 to react with a monosilane gas, thereby forming a silicon nitride film of 1.0µm thickness on the silicon substrate 112.

The film formation rate of this silicon nitride film exhibited a very high value of 520 nm/min. The film quality was confirmed to be excellent, that is, the stress was 1.3 x 10⁹ dyne/cm² (compression), the leakage current was 1.1 x 10⁻¹⁰ A/cm², and the dielectric breakdown voltage was 9 MV/cm. This stress was determined by measuring the warpage of the substrate before and after film formation by using a laser interferometer (trade name: Zygo). The throughput was 42 sheets/hour, which is about 1.7 times as large as the conventional throughput of 25 sheets/hour which was obtained by starting processing after the chamber has been exhausted down to 10⁻⁶ Torr without using a processing gas (nitrogen gas) as a ventilation gas.

### <Example 4>

In this example, a silicon nitride film and an oxide film for preventing reflection of plastic lenses were formed by using a nitrogen gas, an oxygen gas and a monosilane gas as ventilation gases according to the method described with reference to FIGS. 1, 2A and 2B and by using the plasma CVD method.

A plastic convex lens of 50 mm diameter was prepared as a substrate 112. A nitrogen gas was introduced into the plasma processing chamber 101 via the processing gas introduction opening 115 to conduct ventilation. The lens 112 was installed on a substrate supporting member 113, and the inside of the plasma processing chamber 101 was then evacuated via an exhaust system (not shown in the drawings).

When the internal pressure of the chamber reached 5 mTorr, a nitrogen gas and an SiH₄ gas were introduced into the plasma processing chamber 101 via the plasma processing gas introduction opening 115 while gradually increasing the flow rate of the nitrogen gas and the SiH₄ gas up to 150 sccm and 100 sccm, respectively, so as to maintain the pressure at 5 mTorr. At the same time, 3.0 kW power was supplied to the inside of the plasma processing chamber 101 from a 2.45 GHz microwave power supply via an annular waveguide 103 provided with plate-shaped slots to generate plasma in the plasma processing chamber 101. In this case, the nitrogen gas introduced via the plasma processing gas introduction opening 115 was excited and decomposed in the plasma processing chamber 101 to become an active species, which was transported toward the lens 112 to react with a monosilane gas, thereby forming a silicon nitride film of 21 nm thickness on the lens 112.

Next, an oxygen gas and a monosilane gas were introduced into the processing chamber 101 via the plasma processing gas introduction opening 115 at a flow rate of 200 sccm and 100 sccm, respectively. A conductance valve (not shown in the drawings) provided in an exhaust system (not shown in the drawings) was adjusted to maintain the inside of the processing chamber 101 at 1 mTorr. Then, 2.0 kW power was supplied to the inside of the plasma processing chamber 101 from the 2.45 GHz microwave power supply (not shown in the drawings) via the annular waveguide 103 provided with plate-shaped slots to generate plasma in the plasma processing chamber 101. In this case, the oxygen gas introduced via the plasma processing gas introduction opening 115 was excited and decomposed in the plasma processing chamber 101 to become an active species such as oxygen atoms, which was then transported toward the lens 112 to react with a monosilane gas, thereby forming a silicon oxide film of 86 nm thickness on the lens 112.

The film formation rates of the silicon nitride film and the oxide film exhibited satisfactory values of 320 nm/min and 380 nm/min, respectively, and the films were confirmed to exhibit an excellent optical characteristic, that is, the reflectance near 500 nm was 0.3%. The throughput was 31 sheets/hour, which is about 1.4 times as large as the conventional throughput of 22 sheets/hour which was obtained by starting processing after the chamber has been exhausted down to 10⁻⁶ Torr without using of a processing gases (nitrogen gas, oxygen gas and monosilane gas) as ventilation gases.

### <Example 5>

In this example, a silicon oxide film for interlayer insulation of a semiconductor device was formed by using an oxygen gas as a ventilation gas according to the method described with reference to FIG. 1 and by using the plasma CVD method.

A p-type single-crystal silicon substrate (surface azimuth: <100>); resistivity: 10 Ωcm) having an Al pattern (line and space: 0.5 µm) at its top was prepared as a substrate 112. An oxygen gas was introduced into the plasma processing chamber 101 via the processing gas introduction opening 115 to carry out ventilation. The Si substrate 112 was installed on a substrate supporting member 113 that had been heated up to 300°C by a heater 104, and the inside of the plasma processing chamber 101 was then evacuated to be in a vacuum state via an exhaust system (not shown in the drawings).

When the internal pressure of the chamber reached 30 mTorr, an oxygen gas and an SiH₄ gas were introduced into the plasma processing chamber 101 via the plasma processing gas introduction opening 115 while gradually increasing the flow rate of the oxygen gas and the SiH₄ gas up to 500 sccm and 200 sccm, respectively, so as to maintain the pressure at 30 mTorr. At the same time, while a RF bias (not shown in the drawings) of 200 W power was applied to the substrate supporting member 113, 2.0 kW power was supplied to the inside of the plasma processing chamber 101 from a 2.45 GHz microwave power supply via an annular waveguide 103 provided with plate-shaped slots to generate plasma in the plasma processing chamber 101. In this case, the oxygen gas introduced via the plasma processing gas introduction opening 115 was excited and decomposed in the plasma processing chamber 101 to become an active species, which was transported toward the silicon substrate 112 to react with a monosilane gas, thereby forming a silicon oxide film of 0.8µm thickness on the silicon substrate 112. In addition, the ion species was accelerated by an RF bias (not shown in the drawings) to collide the substrate, so that it cut the film on the pattern to improve its flatness.

The film formation rate of the silicon oxide film and its uniformity exhibited a satisfactory value of 250 nm/min ± 2.3 %, and the film quality was confirmed to be excellent, that is, the dielectric breakdown voltage was 8.3 MV/cm and no void was observed in the step coverage property. This step coverage property was evaluated by observing the cross section of the silicon oxide film formed on the Al wiring pattern in respect of voids with a scanning electron microscope (SEM). The throughput was 53 sheets/hour, which is about 1.5 times as large as the conventional throughput of 35 sheets/hour which was obtained by starting processing after the chamber has been exhausted down to 10⁻⁶ Torr without using a processing gas (oxygen gas) as a ventilation gas.

### <Example 6>

In this example, an interlayer SiO₂ film for a semiconductor device was etched by using a carbon fluoride (CF₄) as a ventilation gas, according to the method described with reference to FIG. 1.

A p-type single-crystal silicon substrate (surface azimuth: <100>); resistivity: 10 Ωcm) having an interlayer SiO₂ film of 1 µm thickness on an Al pattern (line and space: 0.35 µm) was prepared as a substrate 112. A CF₄ gas was introduced into the plasma processing chamber 101 via the processing gas introduction opening 115 to carry out ventilation. The Si substrate 112 was installed on a substrate supporting member 113 and the plasma processing chamber 101 was then evacuated to be a vacuum state by an exhaust system (not shown in the drawings).

When the internal pressure of the chamber reached 5 mTorr, a CF₄ gas was introduced into the plasma processing chamber 101 via the plasma processing gas introduction opening 115 while gradually increasing the flow rate of the gas up to 300 sccm so as to maintain the pressure at 5 mTorr. At the same time, while a 300 W RF bias (not shown in the drawings) was applied to the substrate supporting member 113, 2.0 kW power was supplied to the inside of the plasma processing chamber 101 from a 2.45 GHz microwave power supply via an annular waveguide 103 provided with plate-shaped slots to generate plasma in the plasma processing chamber 101. In this case, the CF₄ gas introduced via the plasma processing gas introduction opening 115 was excited and decomposed in the plasma processing chamber 101 to become an active species, which was transported toward the silicon substrate 112, where the ions accelerated by the self-bias etched the interlayer SiO₂ film.

The etching rate and the selection ratio with respect to polysilicon rate exhibited satisfactory values of 600 nm/min. and 20, respectively, the etching shape was almost perpendicular, and few micro-loading effects were observed. The etching shape was evaluated by observing the cross section of the etched silicon oxide film using a scanning electron microscope (SEM). The throughput was 43 sheets/hour, which was about 1.3 times as large as the conventional throughput of 33 sheets/hour which was obtained by starting processing after the chamber has been exhausted down to 10⁻⁶ Torr without using a processing gas (CF₄ gas) as a ventilation gas.

As described above, according to the plasma processing method of the present invention, it is possible to reduce the time required for operations other than plasma processing, in particular, the exhaust time to thereby carry out the entire processing at a higher speed.

The present invention provides a plasma processing method of conducting plasma processing such as CVD, etching or ashing that can reduce an exhaust time to increase the speed of the entire processing, which method comprises using as a ventilation gas a gas containing at least one component (O₂, N₂, CF₄ or the like) of a plasma processing gas, exhausting the ventilation gas, when a pressure reaches a plasma processing pressure value by the exhaust, introducing the plasma processing gas so as to maintain the plasma processing pressure and starting plasma processing.

## Claims

1. A plasma processing method comprising the steps of:
introducing a ventilation gas into a processing chamber (101; 201; 401) and arranging a substrate (112; 212) to be processed within the processing chamber;
exhausting the ventilation gas; and
introducing a plasma processing gas into the processing chamber and starting plasma processing of the substrate when the internal pressure of the processing chamber reaches a predetermined pressure value during the step of exhausting the ventilation gas,
**characterized in that**
said ventilation gas is a gas containing at least one component of the plasma processing gas required for effecting the plasma processing of the substrate; and
said predetermined pressure value is not more than an internal pressure maintained in the step of plasma processing the substrate and not less than a pressure value smaller by one figure than the internal pressure maintained in the step of plasma processing the substrate.

2. A plasma processing method according to claim 1, wherein in the step of plasma processing the substrate, the internal pressure of the processing chamber (101) is maintained by gradually increasing a flow rate of the plasma processing gas.

3. A plasma processing method according to claim 1, wherein in the step of plasma processing the substrate, the internal pressure of the processing chamber (201) is maintained by decreasing an exhaust rate of the inside of the processing chamber.

4. A plasma processing method according to claim 1, wherein the plasma processing is ashing.

5. A plasma processing method according to claim 1, wherein the plasma processing is etching.

6. A plasma processing method according to claim 1, wherein the plasma processing is CVD.

7. A plasma processing method according to claim 1, wherein a microwave multislot antenna (102-106; 202-206) is used to introduce electric energy into the processing chamber (101; 201; 401) to generate plasma therein.

8. A plasma processing method according to claim 1, wherein the substrate (112; 212) is arranged in the processing chamber while flowing the ventilation gas.

9. A plasma processing method according to claim 1, wherein the substrate (212) is arranged in the processing chamber (401) by opening the processing chamber to the ventilation gas at an ambient atmosphere.

10. A plasma processing method according to claim 1, wherein the ventilation gas is introduced into the processing chamber (101; 201; 401) subsequently after completing the plasma processing of a previous substrate.

11. A plasma processing method according to claim 1, wherein the predetermined pressure value is not less than 90% of the internal pressure maintained in the step of plasma processing the substrate.

12. Use of a plasma processing apparatus having processing gas flow rate control means (117) for carrying out the plasma processing method of claim 2.

13. Use of a plasma processing apparatus having an exhaust conductance control valve (218) for carrying out the plasma processing method of claim 3.

14. Use of a plasma processing apparatus having a ventilation gas chamber (421) separated from the processing chamber (401) for carrying out the plasma processing method of claim 9.

## Patentansprüche

1. Plasmabearbeitungsverfahren mit den Schritten:
Einleiten eines Belüftungsgases in eine Bearbeitungskammer (101; 201; 401) und Anordnen eines zu bearbeitenden Substrats (112; 212) innerhalb der Bearbeitungskammer;
Absaugen des Belüftungsgases; und
Einleiten eines Plasmabearbeitungsgases in die Bearbeitungskammer und Beginnen der Plasmabearbeitung des Substrats, wenn der Innendruck der Bearbeitungskammer während des Schritts Absaugen des Belüftungsgases einen vorbestimmten Druckwert erreicht,
**dadurch gekennzeichnet, dass**
das Belüftungsgas ein Gas ist, das mindestens einen Bestandteil des Plasmabearbeitungsgases enthält, das zur Ausführung der Plasmabearbeitung des Substrats erforderlich ist; und
der vorbestimmte Druckwert nicht höher als ein Innendruck ist, der in dem Schritt Plasmabearbeiten des Substrats gehalten wird, und nicht geringer als ein Druckwert ist, der um eine Stelle kleiner als der in dem Schritt Plasmabearbeiten des Substrats gehaltene Innendruck ist.

2. Plasmabearbeitungsverfahren nach Anspruch 1, bei dem der Innendruck der Bearbeitungskammer (101) in dem Schritt Plasmabearbeiten des Substrats beibehalten wird, indem eine Durchflussmenge des Plasmabearbeitungsgases allmählich erhöht wird.

3. Plasmabearbeitungsverfahren nach Anspruch 1, bei dem der Innendruck der Bearbeitungskammer (201) in dem Schritt Plasmabearbeiten des Substrats beibehalten wird, indem eine Absaugrate des Inneren der Bearbeitungskammer verringert wird.

4. Plasmabearbeitungsverfahren nach Anspruch 1, bei dem die Plasmabearbeitung Veraschen ist.

5. Plasmabearbeitungsverfahren nach Anspruch 1, bei dem die Plasmabearbeitung Ätzen ist.

6. Plasmabearbeitungsverfahren nach Anspruch 1, bei dem die Plasmabearbeitung CVD ist.

7. Plasmabearbeitungsverfahren nach Anspruch 1, bei dem eine Mikrowellen-Mehrschlitz-Antenne (102-106; 202-206) verwendet wird, um elektrische Energie in die Bearbeitungskammer (101; 201; 401) einzuleiten, um darin Plasma zu erzeugen.

8. Plasmabearbeitungsverfahren nach Anspruch 1, bei dem das Substrat (112; 212) in der Bearbeitungskammer angeordnet wird, während das Belüftungsgas strömt.

9. Plasmabearbeitungsverfahren nach Anspruch 1, bei dem das Substrat (212) in der Bearbeitungskammer (401) angeordnet wird, indem die Bearbeitungskammer zum Belüftungsgas hin bei einer Umgebungsatmosphäre geöffnet wird.

10. Plasmabearbeitungsverfahren nach Anspruch 1, bei dem das Belüftungsgas im Anschluss an die Beendigung der Plasmabearbeitung eines vorherigen Substrats in die Bearbeitungskammer (101; 201; 401) eingeleitet wird.

11. Plasmabearbeitungsverfahren nach Anspruch 1, bei dem der vorbestimmte Druckwert nicht weniger als 90% des in dem Schritt Plasmabearbeiten des Substrats gehaltenen Innendrucks beträgt.

12. Verwendung einer Plasmabearbeitungsvorrichtung mit einer Bearbeitungsgasdurchflussmengen-Steuerungseinrichtung (117) zur Durchführung des Plasmabearbeitungsverfahrens gemäß Anspruch 2.

13. Verwendung einer Plasmabearbeitungsvorrichtung mit einem Absaugleitfähigkeits-Steuerungsventil (218) zur Durchführung des Plasmabearbeitungsverfahrens gemäß Anspruch 3.

14. Verwendung einer Plasmabearbeitungsvorrichtung mit einer von der Bearbeitungskammer (401) getrennten Belüftungsgaskammer (421) zur Durchführung des Plasmabearbeitungsverfahrens gemäß Anspruch 9.

## Revendications

1. Procédé de traitement au plasma comprenant les étapes consistant à :
introduire un gaz de ventilation dans une chambre de traitement (101 ; 201 ; 401) et à disposer un substrat (112 ; 212) à traiter à l'intérieur de la chambre de traitement ;
à éjecter le gaz de ventilation ; et
à introduire un gaz de traitement au plasma dans la chambre de traitement et à démarrer le traitement au plasma du substrat lorsque la pression interne de la chambre de traitement atteint une valeur de pression prédéterminée pendant l'étape consistant à éjecter le gaz de ventilation,
**caractérisé en ce que**
ledit gaz de ventilation est un gaz contenant au moins un composant du gaz de traitement au plasma requis pour affecter le traitement au plasma du substrat ; et
ladite valeur de pression prédéterminée n'est pas supérieure à une pression interne maintenue dans l'étape de traitement au plasma du substrat et non inférieure à une valeur de pression inférieure par un ordre de grandeur à la pression interne maintenue dans l'étape de traitement au plasma du substrat.

2. Procédé de traitement au plasma selon la revendication 1, dans lequel dans l'étape de traitement au plasma du substrat, la pression interne de la chambre de traitement (101) est maintenue en augmentant graduellement un débit du gaz de traitement au plasma.

3. Procédé de traitement au plasma selon la revendication 1, dans laquelle dans l'étape de traitement au plasma du substrat, la pression interne de la chambre de traitement (201) est maintenue en diminuant un débit d'évacuation de l'intérieur de la chambre de traitement.

4. Procédé de traitement au plasma selon la revendication 1, dans laquelle le traitement au plasma se fait par incinération.

5. Procédé de traitement au plasma selon la revendication 1, dans laquelle le traitement au plasma se fait par décapage.

6. Procédé de traitement au plasma selon la revendication 1, dans laquelle le traitement au plasma se fait par CVD (dépôt chimique en phase vapeur).

7. Procédé de traitement au plasma selon la revendication 1, dans laquelle une antenne à plusieurs intervalles de temps à micro-ondes (102-106 ; 202-206) est utilisée pour introduire une énergie électrique dans la chambre de traitement (101 ; 201 ; 401) pour y générer un plasma.

8. Procédé de traitement au plasma selon la revendication 1, dans laquelle le substrat (112-212) est disposé dans la chambre de traitement tout en faisant circuler le gaz de ventilation.

9. Procédé de traitement au plasma selon la revendication 1, dans laquelle le substrat (212) est disposé dans la chambre de traitement (401) en ouvrant la chambre de traitement au gaz de ventilation à une atmosphère ambiante.

10. Procédé de traitement au plasma selon la revendication 1, dans laquelle le gaz de ventilation est introduit dans la chambre de traitement (101 ; 201 ; 401) après avoir terminé le traitement au plasma d'un substrat antérieur.

11. Procédé de traitement au plasma selon la revendication 1, dans laquelle la valeur de pression prédéterminée n'est pas inférieure à 90 % de la pression interne maintenue dans l'étape de traitement au plasma du substrat.

12. Utilisation d'un appareil de traitement au plasma ayant un dispositif de contrôle du débit de gaz de traitement (117) pour mettre en oeuvre le procédé de traitement au plasma de la revendication 2.

13. Utilisation d'un appareil de traitement au plasma ayant une soupape de contrôle de conductance d'évacuation (218) pour mettre en oeuvre le procédé de traitement au plasma de la revendication 3.

14. Utilisation d'un appareil de traitement au plasma ayant une chambre de gaz de ventilation (421) séparée de la chambre de traitement (401) pour mettre en oeuvre le procédé de traitement au plasma de la revendication 9.
